# DEMANDE DE BREVET EUROPEEN

(11) **EP 0 734 063 A2**
(43) Date de publication de la demande: **25.09.1996**
(21) Numéro de dépôt: 96106073.8
(22) Date de dépôt: 18.02.1992
(51) Int. Cl.: H01L 23/495, H01L 23/498

(54) **Micromodule de circuit intégré obtenu par un procédé d'assemblage en continu de bandes à motifs**

(30) Priorité: 19.02.1991 FR 9101934
(62) Demande divisionnaire de: 92906568.8
(71) Demandeur: GEMPLUS, 13420 Gemenos (FR)
(72) Inventeur: Gloton, Jean-Pierre, 94230 Cachan (FR); Laroche, Damien, 94230 Cachan (FR); Turin, Joel, 94230 Cachan (FR); Fallah, Michel, 94230 Cachan (FR)
(74) Mandataire: Schmit, Christian Norbert Marie

(57) **Abrégé**

L'invention concerne un micromodule de circuit intégré. Ce micromodule est caractérisé en ce qu'il comporte une grille métallique découpée 10 collée contre une bande diélectrique perforée 11 d'épaisseur inférieure à 70 µm, avec une puce 100 collée sur la bande diélectrique ou sur la grille métallique et connectée à la bande métallique à travers les perforations P₁ de la bande diélectrique.

Application : fabrication de "cartes à puces".

## Description

La présente invention concerne un micromodule de circuit intégré obtenu par un procédé d'assemblage en continu de bandes à motifs.

Elle s'applique notamment à des micromodules en circuit intégré, entrant dans la fabrication des cartes plates portables dites "cartes à puces". Dans ces cartes, les micromodules sont formés par un ensemble d'éléments composé : d'une puce en circuit intégré, de contacts métalliques servant de connexion du micromodule avec des dispositifs extérieurs, de fils de liaison pour relier la puce aux contacts métalliques et d'une protection formée d'une résine recouvrant la puce, les fils de liaison, et, partiellement les contacts métalliques.

Pour fabriquer un micromodule et l'incorporer ensuite à une carte, un premier procédé connu consiste à reporter la puce sur une bande métallique prédécoupée en forme de grille de conducteur, à souder la puce sur une plage de cette grille où elle est reliée par des fils soudés à d'autres plages de la grille, à enrober la puce et les fils par une goutte de résine de protection de type époxy ou silicone en laissant les conducteurs de la grille partiellement dénudés, à découper la bande métallique en micromodules individuels comprenant chacun une puce enrobée et des contacts extérieurs dénudés et à coller le micromodule dans une cavité superficielle d'une carte en matière plastique, de telle sorte que, des portions de grilles non enrobées de résine affleurent et constituent le connecteur extérieur de la carte.

Selon un deuxième procédé également connu, la bande métallique prédécoupée de départ est remplacée par une bande diélectrique métallisée gravée selon un motif de connexion à déterminer. La bande diélectrique forme dans ce cas le support principal de la puce. Les connexions ont une très faible épaisseur et sont obtenues par pré-dépôt d'une couche métallique sur la bande plastique de photogravure de cette couche métallique. La puce est reliée par des fils soudés à des plages de la couche métallisée.

Les micromodules obtenus par ces procédés présentent un certain nombre d'inconvénients. Dans le cas d'utilisation d'une bande métallique prédécoupée, la résine d'encapsulation du micromodule adhère mal sur les conducteurs de la grille, ceci d'autant plus que pratiquement la résine se situe d'un seul côté de la bande, l'autre étant réservé pour laisser les conducteurs accessibles pour servir de connecteurs. Il en résulte un problème de fiabilité difficilement soluble, causé principalement par le passage d'humidité entre la résine et les conducteurs.

Dans le cas de l'utilisation d'une bande diélectrique métallisée et photogravée, il faut nécessairement que la bande soit constituée de matière suffisamment rigide et ait une bonne tenue à la température pour ne pas se gondoler lorsque la température s'élève ce qui impose que la définition du motif de conducteur ne soit exécutée que par photogravure sur la bande diélectrique et rend ce deuxième procédé beaucoup plus coûteux qu'un découpage mécanique, par exemple.

Un troisième procédé est connu par la demande de brevet européen publiée sous le n° 0 296 511 déposée sous le n° 88 1097430 le 18 juin 1988.

Cette demande de brevet concerne un procédé de fabrication d'un ruban destiné à fournir des modules pour équiper des cartes électroniques appelées aussi "smart cards". Cependant la solution proposée dans cette demande n'est pas satisfaisante.

En effet, selon ce procédé, on se munit d'une bande métallique dont l'épaisseur est typiquement de 75 micromètres, mais qui peut varier entre 50 et 150 micromètres. Cette bande est pourvue de perforations permettant son entraînement et d'ouvertures obtenues par étampage, délimitant les réseaux de conducteurs des circuits. On se munit également d'un ensemble de feuilles isolantes de 125 micromètres d'épaisseur portant sur une face une matière thermoplastique ou thermodurcissable pour un collage à chaud. Les feuilles comportent un ensemble de trous dont la disposition correspond à l'emplacement des connexions et un trou central pour l'emplacement du circuit.

Les feuilles sont collées sur la bande métallique par chauffage. Le chauffage provoque un certain retrait du matériau isolant rendant difficile l'utilisation de feuilles plus grandes surtout dans le sens longitudinal. Avec un collage à froid le problème ne se poserait pas, en revanche l'adhérence sur le métal est mauvaise.

D'autre part, il est impératif de réaliser une perforation dans chaque feuille d'isolant à l'emplacement réservé pour le circuit afin d'y loger le circuit et de rentrer ainsi dans les tolérances exigées sur l'épaisseur pour la fabrication des cartes à puces.

On peut citer étalement comme état de la technique le document GB 2021796 A qui décrit un dispositif d'assemblage d'une bande isolante adhésive sur une bande conductrice. Dans le dispositif décrit, le réglage de la tension ne se fait que sur la bande isolante en modifiant la vitesse de rotation des roues entre lesquelles passe cette bande. Un tel dispositif ne permet pas l'emploi de bandes isolantes très fines de 30 à 50 µm comme le permet l'invention.

Le procédé de fabrication du micromodule selon la présente invention permet de résoudre ces problèmes et permet l'emploi d'une bande de matériau isolant beaucoup moins épais que ce qu'il est usuel d'utiliser comme épaisseur d'isolant. Ceci permet de laisser le choix au fabricant en fonction par exemple de l'utilisation qui sera faite, de placer le circuit soit sur la bande d'isolant, soit sur la bande métallique. En effet, conformément à l'invention la bande diélectrique peut avoir une épaisseur très faible de l'ordre de 30 à 50 µm au lieu de 100 à 200 µm.

Le collage d'une puce de circuit intégré peut par conséquent avoir lieu entre la bande diélectrique mince, la formation des connexions électriques à la puce s'effectuant alors à travers des découpes de la bande diélectrique. De toutes les façons l'épaisseur globale du micromodule est ainsi considérablement réduite dans un rapport décisif qui donne la possibilité de fabriquer des cartes à puces très plates.

Dans le cas où la puce est collée sur la bande diélectrique au lieu d'être collée sur la surface métallique, on a un facteur de sécurité supplémentaire, car le diélectrique mince placé sous la puce peut jouer alors un rôle de tampon élastique évitant d'éventuelles détériorations.

La présente invention a donc pour objet un micromodule de circuit intégré comportant une grille métallique découpée, une bande diélectrique perforée d'épaisseur inférieure à 70 µm, une puce collée soit sur cette bande diélectrique, soit sur la bande métallique à travers une perforation de la bande diélectrique et connectée à la bande métallique à travers d'autres perforations de la bande diélectrique.

La présente invention a aussi pour objet un micromodule de circuit intégré dans lequel la bande diélectrique recouvrant la grille constitue le diélectrique d'une antenne électromagnétique d'émission et/ou réception, dont la grille prédécoupée constitue une partie active.

D'autres caractéristiques et avantages de l'invention apparaîtront à l'aide de la description qui suit faite en regard des dessins annexés qui représentent :
- la figure 1, une vue de dessus d'une bande métallique prédécoupée selon l'invention,
- la figure 2, une vue de dessus d'une bande diélectrique perforée selon l'invention, destinée à être collée sur la bande métallique de la figure 1,
- la figure 3, une vue montrant la juxtaposition des deux bandes en cours de collage,
- la figure 4, le micromodule selon l'invention, à un stage intermédiaire de fabrication,
- la figure 5, un micromodule selon l'invention à un stade final de fabrication,
- la figure 6, un micromodule constituant une antenne émission/réception,
- la figure 7, un micromodule constituant une étiquette d'identification.

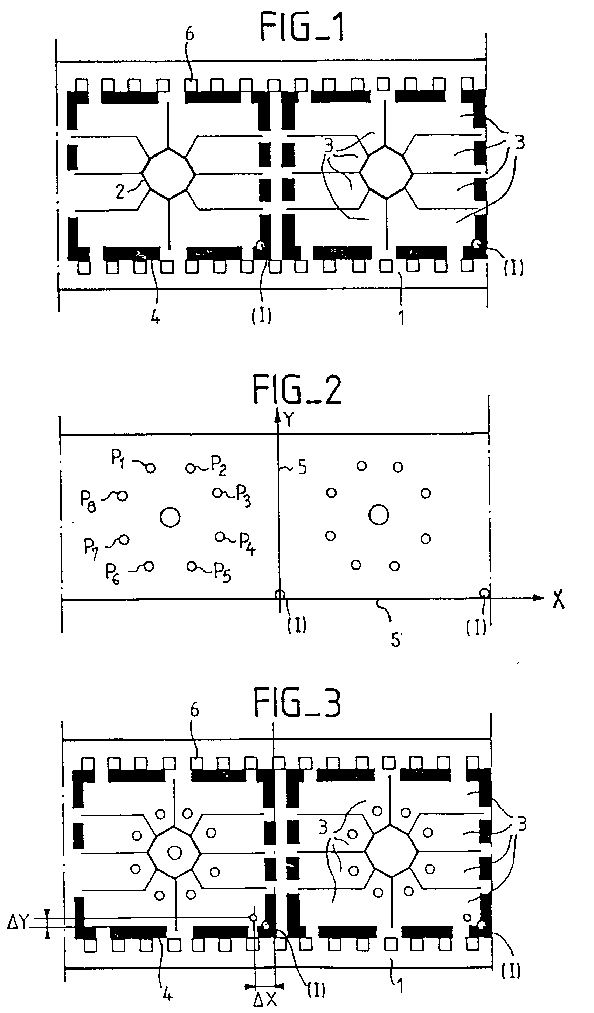

La bande métallique prédécoupée 1 qui est représentée à la figure 1, est formée d'une bande de cuivre ou de cuivre étamé d'épaisseur d'environ 35 à 70 µm. Sa largeur est définie pour correspondre à la largeur de connexion finale à réaliser et peut être de l'ordre de 1 cm à quelques centimètres selon le cas. Elle comporte un découpage d'un motif répétitif 2 réalisé éventuellement par matriçage définissant les contacts séparés 3 qui servent de broche de connexion entre l'intérieur et l'extérieur du micromodule à assembler sur le ruban.

Dans la représentation de la figure 1 qui est donnée à titre d'exemple, le motif 2 est celui qui permet la connexion d'un micromodule pour carte à puce plate, les contacts représentés étant au nombre de huit. Les huit contacts séparés 3 sont visibles à l'intérieur d'une ligne fermée 4. Ceux-ci sont séparés par des lignes de découpe 5 des motifs 2. A l'extérieur de la ligne 4, les contacts sont réunis pour assurer la continuité de la bande d'un micromodule à un autre.

La bande 1 comporte des perforations régulières 6 réparties le long des bords longitudinaux de la bande sur un côté ou sur les deux côtés de celle-ci. Ces perforations servent à l'entraînement de la bande par un système à roue dentée d'un dispositif d'assemblage en continu.

La bande métallique découpée forme le support principal des puces qui constituent le coeur des micromodules. Cette bande est recouverte d'une bande diélectrique du type de celle représentée à la figure 2 comportant des perforations prédécoupées (P₁-P₈) destinées à venir en regard des plages conductrices 3 du motif de conducteur découpé dans la bande métallique 1. Un trou d'indexation (I) sert de repère et permet le positionnement précis des perforations (P₁-P₈) en face des plages conductrices 3 lors du procédé de fabrication en continu.

Comme l'indique la figure 3, le trou d'indexation est situé, lorsque l'opération de collage est terminée, à l'intersection de deux axes de collage respectivement horizontal X et vertical Y formés par les lignes de découpe. Ce positionnement est réalisé par un dispositif d'assemblage de bande.

En principe, la bande diélectrique sera plus étroite que la bande métallique, elle ne comportera pas de découpes latérales périodiques permettant un entraînement par roues dentées, et elle sera d'ailleurs en général trop mince pour permettre un entraînement par roue dentée. Lors du collage de la bande diélectrique contre la bande métallique, les découpes permettant l'entraînement de la bande métallique ne seront pas recouverts par la bande diélectrique grâce à la largeur inférieure de celle-ci.

Les autres opérations de fabrication peuvent être classiques, par exemple : dépôt d'une goutte de résine pour enrober la puce et les connexions de liaison avec la puce, du côté de la bande diélectrique mais pas du côté de la bande métallique ; et éventuellement arasage de la goutte à une hauteur prédéterminée ; séparation du micromodule d'avec le reste de la bande, le micromodule est alors prêt à être inséré dans une cavité d'une carte plastique.

On remarque en outre que par ce procédé ce n'est plus la bande diélectrique qui sert à entraîner l'ensemble lors de la fabrication en chaîne de micromodules à partir d'une bande continue, comme cela a pu être le cas dans des techniques antérieures lorsqu'une bande diélectrique était prévue. L'épaisseur de la bande diélectrique est beaucoup plus faible que dans l'art antérieur 30 à 50 µm au lieu de 100 à 200 µm par exemple. Cela est très important car l'épaisseur globale du micromodule est un facteur décisif pour la possibilité de faire des cartes à puces très plates.

D'autre part, compte-tenu de cette très faible épaisseur, la puce peut être collée sur la bande diélectrique ou sur la bande métallique. Les cas dans lesquels il n'est pas nécessaire de prévoir un contact de face arrière pour la puce sont en effet fréquents en technologie CMOS. Lorsque des contraintes mécaniques s'exercent sur la carte, le diélectrique mince placé sous la carte joue le rôle de tampon élastique ce qui dans certains cas permet d'éviter que la puce ne se détériore.

Lors de la fabrication, la faible épaisseur de la bande diélectrique facilite un collage très efficace des deux bandes l'une contre l'autre, sans risque de décollement lors du traitement ultérieur.

Enfin, un autre avantage de l'invention est que le collage de la puce sur le diélectrique permet de prévoir une seule chaîne de fabrication de micromodules quel que soit la dimension de la puce à encapsuler, et cela à partir d'un seul modèle de bande métallique prédécoupée, à la seule condition de prévoir un outil de découpe modifiable ou amovible pour la formation des découpes dans la bande diélectrique ; en effet, la puce est isolée de la grille métallique, et seul l'emplacement des perforations dans le diélectrique définit la position des connexions entre la puce et la grille ; pour une puce de plus grande taille, on placera les perforations plus éloignées du centre de la puce ; pour une puce plus petite, on rapprochera les perforations du centre ; il suffit bien entendu que les perforations restent au-dessus des plages métalliques qui conviennent, mais ces plages peuvent être assez larges dans le cas de micromodules à faible nombre de contacts extérieurs (6 ou 8 par exemple).

Le micromodule selon l'invention comporte une grille métallique découpée collée contre la bande diélectrique perforée très mince (épaisseur de préférence inférieure à 50 µm, plus généralement entre environ 30 et 70 µm), avec une puce 100 collée soit sur la bande métallique, soit sur la bande diélectrique et connectée, par l'intermédiaire de fils 103, à la bande métallique à travers les perforations de la bande diélectrique.

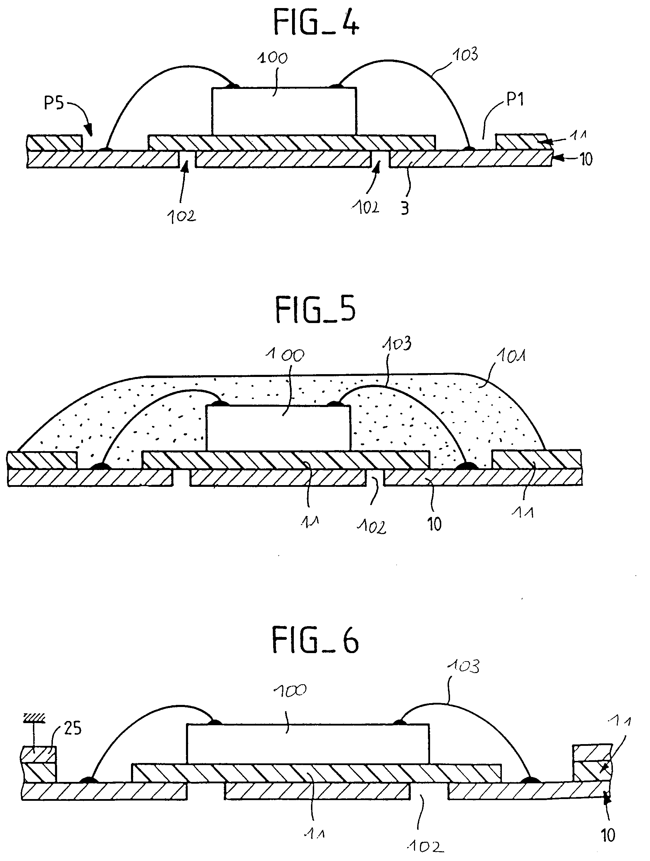

La figure 4 représente la bande composite portant une puce à ce stade de fabrication.

La puce 100 est ensuite enrobée d'un isolant de protection 101 de préférence une résine époxy ou une résine aux silicones que l'on peut déposer en goutte au-dessus de la puce (figure 5).

On notera contrairement à ce qui se passe dans la technique utilisant une bande métallique découpée sans diélectrique, la résine ne peut pas couler entre les conducteurs 3, c'est-à-dire dans les découpes 102 de la bande métallique puisqu'en principe toutes ces découpes 102 sont recouvertes par la bande diélectrique, au moins dans la partie qui constituera le micromodule après découpe de la bande.

Les contraintes mécaniques sur la puce sont particulièrement faibles, pendant et après la fabrication, du fait de l'interposition entre le métal et la puce d'une faible épaisseur de polyimide qui se comporte comme un tampon de matière élastique. Cela est important lorsque le micromodule est incorporé à une carte à puce plate car ces cartes sont sujettes à des contraintes de torsion et flexion très importantes.

Étant donné que l'on peut se contenter d'une très faible épaisseur de diélectrique, la hauteur du micromodule reste limitée à une valeur acceptable malgré le fait que la puce repose sur le diélectrique. A titre indicatif, la puce peut avoir une épaisseur de 250 µm environ et les bandes 10 et 11 une épaisseur de 50 µm chacune.

La résine d'encapsulation adhère sur une surface diélectrique, ce qui est meilleur que sur une surface métallique. Il n'y a pas de risque de pénétration d'humidité jusqu'à la puce qui est entourée de résine partout où elle ne touche pas la bande diélectrique.

Lorsque le micromodule est terminé (figure 5), éventuellement après arasage de la résine à une hauteur maximale désirée, on le sépare du reste de la bande par une découpe mécanique selon la ligne 4 des figures 1 et 2. S'il s'agit d'un micromodule pour carte à puce dont le connecteur est constitué par la face accessible des conducteurs 3, on place le micromodule dans une cavité de la carte à puce, la face portant la puce étant tournée vers le fond de la cavité et les conducteurs restant accessibles à la partie supérieure.

Dans un perfectionnement de l'invention cf. figure 6, tout particulièrement intéressant dans le cas de cartes à puces fonctionnant en hyperfréquences et destinées à recevoir et/ou émettre un rayonnement électromagnétique, on peut prévoir que la bande diélectrique 11 constitue le diélectrique d'une antenne rayonnante, dont la grille découpée 10, constitue une partie active. L'antenne est de type microstrip, constituée par exemple à partir de conducteurs découpés dans la bande métallique et qui servent d'antenne au lieu de servir de connecteurs ; un plan de masse électrique peut alors être prévu de l'autre côté du diélectrique ; ce plan de masse peut être réalisé soit à l'aide d'une deuxième bande métallique 10 découpée mécaniquement et collée contre la face supérieure de la bande diélectrique 11 avant mise en place des puces, soit à l'aide d'une métallisation photogravée sur la face supérieure du diélectrique. Inversement, on peut prévoir que le plan de masse est au-dessous (formé dans la bande métallique 10) et l'antenne microstrip au-dessus (formée dans la métallisation d'une bande diélectrique 11 métallisée, ou formée dans une deuxième bande métallique collée du côté de la puce).

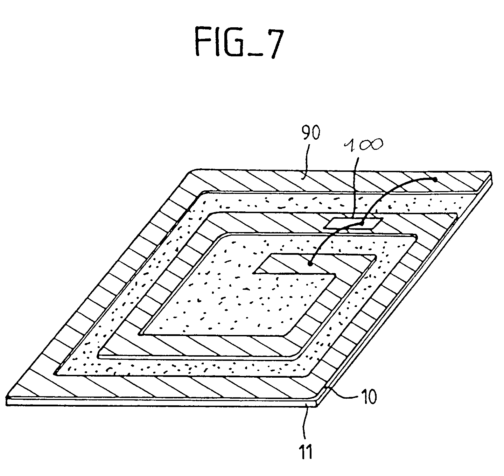

Selon une variante de réalisation, le micromodule peut constituer une étiquette d'identification. Pour cela, la grille 10 forme une inductance. La puce 100 peut être placée sur une zone métallique et être connectée aux deux extrémités de l'inductance 90. Avantageusement, on prendra un diélectrique peu onéreux comme par exemple du carton. Un tel micromodule est représenté sur la figure 7 et constitue une étiquette d'identification à bas coût.

## Revendications

1. Micromodule, caractérisé en ce qu'il comporte une grille métallique découpée (10) collée contre une bande diélectrique perforée (11) d'épaisseur inférieure à 70 µm, avec une puce (100) collée sur la bande diélectrique ou sur la grille métallique et connectée à la bande métallique à travers les perforations (P₁) de la bande diélectrique.

2. Micromodule selon la revendication 1, caractérisé en ce que la bande diélectrique recouvrant la grille constitue le diélectrique d'une antenne d'émission et/ou réception électromagnétique dont la grille prédécoupée constitue une partie active.

3. Micromodule selon la revendication 1 ou 2, caractérisé en ce que la grille métallique constitue une inductance (90) et en ce que la puce est connectée aux extrémités de l'inductance.

4. Micromodule selon l'une quelconque des revendications 1 à 3, caractérisé en ce que la bande d'isolant (11) est en Kapton.

5. Micromodule selon l'une quelconque des revendications 1 à 3, caractérisé en ce que la bande d'isolant est en carton.

6. Micromodule selon la revendication 3, caractérisé en ce qu'il constitue une étiquette d'identification.
